# EUROPEAN PATENT APPLICATION

(11) **EP 4 543 163 A1**
(43) Date of publication of application: **23.04.2025**
(21) Application number: 24203002.1
(22) Date of filing: 26.09.2024
(51) Int. Cl.: H10D 62/13, H10D 30/01, H10D 30/00, H10D 62/10, H10D 64/01

(54) **SEMICONDUCTOR DEVICE AND METHOD OF MANUFACTURING SEMICONUCTOR DEVICE**

(30) Priority: 18.10.2023 KR 20230139862
(71) Applicant: Samsung Electronics Co., Ltd., Suwon-si, Gyeonggi-do 16677 (KR)
(72) Inventor: YOO, Jongryeol, 16677 Suwon-si (KR); KIM, Jaejun, 16677 Suwon-si (KR); JANG, Ingyu, 16677 Suwon-si (KR); KIM, Gwangjun, 16677 Suwon-si (KR); KIM, Sunghwan, 16677 Suwon-si (KR); JEONG, Jiwon, 16677 Suwon-si (KR); PYO, Jeongsang, 16677 Suwon-si (KR)
(74) Representative: Marks & Clerk LLP

(57) **Abstract**

A semiconductor device includes a substrate; an active pattern extending on the substrate in a first direction; a plurality of channel layers on the active pattern and spaced apart from each other in a vertical direction; a gate structure crossing the active pattern, the gate structure surrounding the plurality of channel layers and extending in a second direction orthogonal to the first direction; and source/drain patterns on a region of the active pattern on both sides of the gate structure, and having a semiconductor liner layer connected to each of side surfaces of the plurality of channel layers, and a semiconductor filling layer on the semiconductor liner layer. The semiconductor liner layer includes silicon-germanium (SiGe) doped with a first conductivity-type impurity. The semiconductor filling layer includes an epitaxial layer having a germanium (Ge) concentration higher than that of the semiconductor liner layer, and the epitaxial layer is doped with Ga.

## Description

### BACKGROUND

The present disclosure relates to semiconductor devices and methods of manufacturing the same.

As demand for implementation of high performance, high speed, and/or multifunctionality of semiconductor devices increases, the degree of integration of semiconductor devices has been increasing.

Recently, in order to overcome a limitation of operating properties due to a reduction in a size of a planar metal oxide semiconductor FET (MOSFET), semiconductor devices having a three-dimensional channel have been developed.

### SUMMARY

Example embodiments of the inventive concepts provide a semiconductor device having improved electrical properties and reliability.

Example embodiments of the inventive concepts provide a method of manufacturing a semiconductor device having improved electrical properties and reliability.

Example embodiments of the inventive concepts provide a semiconductor device including a substrate; an active pattern extending on the substrate in a first direction; a plurality of channel layers on the active pattern, the plurality of channel layers spaced apart from each other in a vertical direction perpendicular to an upper surface of the substrate; a gate structure crossing the active pattern, the gate structure surrounding the plurality of channel layers and extending in a second direction, the second direction being orthogonal to the first direction; and source/drain patterns on a region of the active pattern on both sides of the gate structure, the source/drain patterns having a semiconductor liner layer connected to each of side surfaces of the plurality of channel layers, and a semiconductor filling layer on the semiconductor liner layer. The semiconductor liner layer may include silicon-germanium (SiGe) doped with a first conductivity-type impurity. The semiconductor filling layer may include an epitaxial layer having a germanium (Ge) concentration greater than a Ge concentration of the semiconductor liner layer, and the epitaxial layer being doped with Ga.

Example embodiments of the inventive concepts further provide a semiconductor device including a substrate; an active pattern extending on the substrate in a first direction; a plurality of channel layers on the active pattern, the plurality of channel layers spaced apart from each other in a vertical direction perpendicular to an upper surface of the substrate; a gate structure crossing the active pattern, the gate structure surrounding the plurality of channel layers and extending in a second direction, the second direction being orthogonal to the first direction; source/drain patterns on a region of the active pattern on both sides of the gate structure, the source/drain patterns having a semiconductor liner layer connected to each of side surfaces of the plurality of channel layers, and a semiconductor contact layer conformally on the semiconductor liner layer, the source/drain patterns define trenches and the semiconductor contact layer covers the semiconductor liner layer within the trenches; a metal-semiconductor compound layer filling the trenches, the metal-semiconductor compound layer in contact with the semiconductor contact layer. The semiconductor liner layer may include a first epitaxial layer doped with a second conductivity-type first impurity. The semiconductor contact layer may include a second epitaxial layer doped with a second conductivity-type second impurity.

Example embodiments of the inventive concepts still further provide a semiconductor device including a substrate having a first region and a second region; a first active pattern and a second active pattern extending in a first direction respectively in the first region and the second region of the substrate; a plurality of first channel layers on the first active pattern, the plurality of first channel layers spaced apart from each other in a vertical direction perpendicular to an upper surface of the substrate; a plurality of second channel layers on the second active pattern, the plurality of second channel layers spaced apart from each other in the vertical direction; a first gate structure crossing the first active pattern, the first gate structure surrounding the plurality of first channel layers and extending in a second direction, the second direction orthogonal to the first direction; a second gate structure crossing the second active pattern, the second gate structure surrounding the plurality of second channel layers and extending in the second direction; first source/drain patterns on a region of the first active pattern on both sides of the first gate structure, the first source/drain patterns having a first semiconductor liner layer connected to each of side surfaces of the plurality of first channel layers, and a semiconductor filling layer on the first semiconductor liner layer; second source/drain patterns on a region of the second active pattern on both sides of the second gate structure, the second source/drain patterns having a second semiconductor liner layer connected to each of side surfaces of the plurality of second channel layers, and a semiconductor contact layer conformally on the second semiconductor liner layer, the second source/drain patterns define trenches and the semiconductor contact layer covers the second semiconductor liner layer within the trenches; a first metal-semiconductor compound layer covering the first semiconductor liner layer and the semiconductor filling layer; a second metal-semiconductor compound layer filling the trenches, the second metal-semiconductor compound layer in contact with the semiconductor contact layer; and first and second contact structures on the first and second metal-semiconductor compound layers, respectively. The first semiconductor liner layer includes silicon-germanium (SiGe) doped with a first conductivity-type impurity, and the semiconductor filling layer includes an epitaxial layer having a germanium (Ge) concentration greater than a Ge concentration of the semiconductor liner layer, and the epitaxial layer is doped with Ga. The second semiconductor liner layer includes a first epitaxial layer doped with a second conductivity-type first impurity, and the semiconductor contact layer includes a second epitaxial layer doped with a second conductivity-type second impurity.

Example embodiments of the inventive concepts provide a method of manufacturing a semiconductor device, the method including preparing, on a substrate, a fin-type structure including first semiconductor patterns and second semiconductor patterns that are formed of different materials and that are alternately stacked, and a dummy gate structure crossing the fin-type structure; forming first recesses for first source/drain patterns by removing portions of the fin-type structure on both sides of the dummy gate structure, both side surfaces of the fin-type structure being exposed in the first recesses; forming gaps between the second semiconductor patterns by removing portions of the first semiconductor patterns below the dummy gate structure from the both side surfaces that are exposed; forming, in each of the first recesses, a first semiconductor liner layer from a bottom surface of the first recesses along side surfaces of the second semiconductor patterns, the first semiconductor liner layer including silicon-germanium (SiGe) doped with a first conductivity-type impurity; conformally forming a first blocking layer on the first semiconductor liner layer; forming a first sacrificial filling layer including SiGe on the first blocking layer, the first sacrificial filling layer filling the first recesses; forming a first semiconductor cap layer on the first sacrificial filling layer; forming an interlayer insulating layer on the substrate, the interlayer insulating layer covering the first semiconductor cap layer; removing the dummy gate structure and forming an active gate structure in a space from which the dummy gate structure is removed and in the gaps; forming a first contact hole in the interlayer insulating layer, the first contact hole extending to the first semiconductor cap layer; removing the first semiconductor cap layer and the first sacrificial filling layer from the first contact hole; providing a high concentration of first conductivity-type impurity to the first blocking layer; forming a semiconductor filling layer containing germanium, the semiconductor filling layer filling a space from which the first sacrificial filling layer is removed; forming a first metal-semiconductor compound layer by silicidizing an upper portion of the semiconductor filling layer; and forming a first contact structure connected to the first metal-semiconductor compound layer in the first contact hole.

Example embodiments of the inventive concepts still further provide a method of manufacturing a semiconductor device, the method including preparing, on a substrate, a fin-type structure including first semiconductor patterns and second semiconductor patterns that are formed of different materials and that are alternately stacked, and a dummy gate structure crossing the fin-type structure; forming second recesses for second source/drain patterns by removing portions of the fin-type structure on both sides of the dummy gate structure, both side surfaces of the fin-type structure being exposed in the second recesses; forming gaps between the second semiconductor patterns by removing portions of the first semiconductor patterns below the dummy gate structure from the both side surfaces that are exposed; forming, in each of the second recesses, a second semiconductor liner layer including silicon (Si) from a bottom surface of the second recesses along side surfaces of the second semiconductor patterns; conformally forming a second blocking layer on the second semiconductor liner layer; forming a second sacrificial filling layer including silicon germanium (SiGe) on the second blocking layer, the second sacrificial filling layer filling the second recesses; forming a second semiconductor cap layer on the second sacrificial filling layer; forming an interlayer insulating layer on the substrate, the interlayer insulating layer covering the second semiconductor cap layer; removing the dummy gate structure and forming an active gate structure in a space from which the dummy gate structure is removed and in the gaps; forming a second contact hole in the interlayer insulating layer, the second contact hole extending to the second semiconductor cap layer; removing the second semiconductor cap layer and the second sacrificial filling layer from the second contact hole; applying a second conductivity-type impurity to the second blocking layer; forming a semiconductor contact layer on the second blocking layer such that a trench from which the second sacrificial filling layer is removed remains; forming a second metal-semiconductor compound layer filling the trench by silicidizing a portion of the semiconductor thin film; and forming a second contact structure connected to the second metal-semiconductor compound layer in the second contact hole.

At least some of the above and other features of the invention are set out in the claims.

### BRIEF DESCRIPTION OF DRAWINGS

The above and other aspects, features, and advantages of the inventive concepts will be more clearly understood from the following detailed description, taken in conjunction with the accompanying drawings, in which:
FIG. 1 is a plan view illustrating a semiconductor device according to some example embodiments of the inventive concepts;
FIG. 2 is a cross-sectional view of the semiconductor device of FIG. 1 taken along line I-I' ;
FIGS. 3A and 3B are cross-sectional views of the semiconductor device of FIG. 1 taken along lines II1-II1' and lines II2-II2', respectively;
FIG. 4 is a graph illustrating a P-type impurity concentration distribution in a first source/drain pattern of FIG. 2;
FIGS. 5A and 5B are graphs illustrating an impurity concentration distribution of first source/drain patterns applicable to various example embodiments of the inventive concepts;
FIG. 6 is a plan view illustrating a semiconductor device according to some example embodiments of the inventive concepts;
FIG. 7 is a cross-sectional view of the semiconductor device of FIG. 6 taken along line I-I' ;
FIGS. 8A and 8B are cross-sectional views of the semiconductor device of FIG. 6 taken along lines II1-II1' and II2-II2', respectively;
FIG. 9 is a graph illustrating an N-type impurity concentration distribution in a second source/drain pattern of FIG. 7;
FIGS. 10A, 10B, 10C and 10D are cross-sectional views illustrating a process of forming a fin structure and a dummy gate structure of a method of manufacturing a semiconductor device according to some example embodiments of the inventive concepts;
FIGS. 11A, 11B, 11C, 11D, 11E and 11F are cross-sectional views illustrating a process of forming a preliminary source/drain pattern of a method of manufacturing a semiconductor device according to some example embodiments of the inventive concepts; and
FIGS. 12A, 12B, 12C, 12D, 12E and 12F are cross-sectional views illustrating a process of forming an active source/drain pattern and a contact structure of a method of manufacturing a semiconductor device according to some example embodiments of the inventive concepts.

### DETAILED DESCRIPTION

Hereinafter, various example embodiments of the inventive concepts will be described in detail with reference to the attached drawings.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

Also, for example, "at least one of A, B, and C" and similar language (e.g., "at least one selected from the group consisting of A, B, and C") may be construed as A only, B only, C only, or any combination of two or more of A, B, and C, such as, for instance, ABC, AB, BC, and AC.

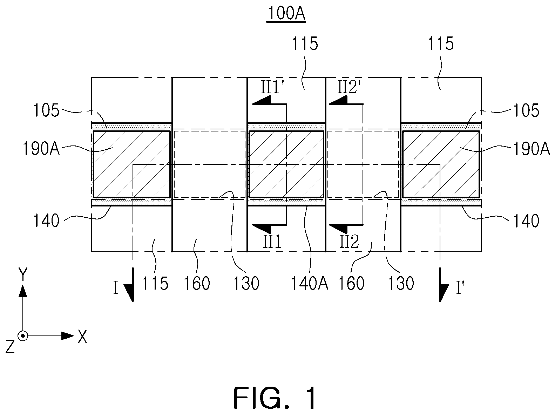

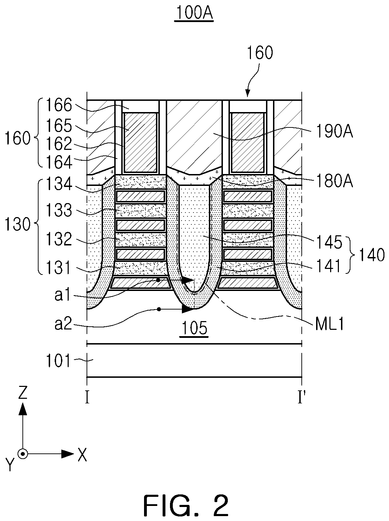

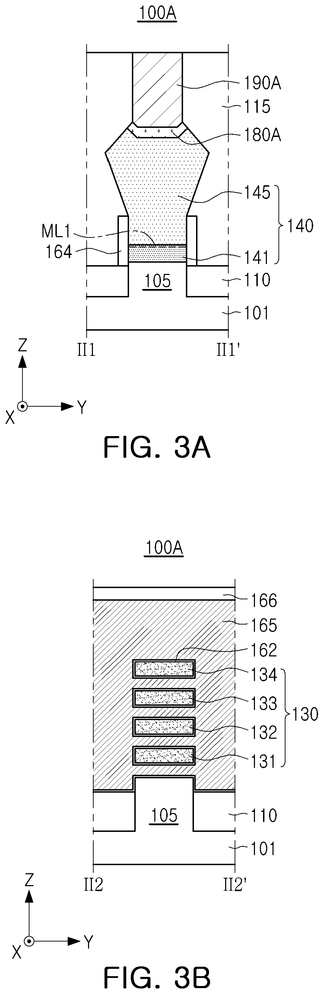

FIG. 1 is a plan view illustrating a semiconductor device according to some example embodiments of the inventive concepts. FIG. 2 is a cross-sectional view of the semiconductor device of FIG. 1 taken along line I-I'. FIGS. 3A and 3B are cross-sectional views of the semiconductor device of FIG. 1 taken along line II1-II1' and line II2-II2', respectively.

Referring to FIGS. 1, 2, 3A, and 3B, a semiconductor device 100A according to some example embodiments may include a substrate 101, an active pattern 105 protruding and extending in a first direction (for example, an X-direction) on the substrate 101, a plurality of channel layers 131, 132, 133, and 134 disposed on the active pattern 105, and a gate structure 160 intersecting the active pattern 105 and extending in a second direction (for example, a Y-direction). The plurality of channel layers 131, 132, 133, and 134 may be disposed on the active pattern 105 to be spaced apart from each other in a direction (for example, a Z-direction), perpendicular to an upper surface of the substrate 101.

The semiconductor device 100A may further include first source/drain patterns 140 (also referred to as "first active source/drains") disposed on both sides of the gate structure 160 to be in contact with both side surfaces of the plurality of channel layers 131, 132, 133, and 134, a first metal-semiconductor compound layer 180A disposed on the first source/drain patterns 140, and first contact plugs 190A connected to the first source/drain patterns 140 through the first metal-semiconductor compound layer 180A. The semiconductor device according to some example embodiments may be a P-type MOSFET.

In some example embodiments, the active pattern 105 may have a fin-type structure extending in the first direction (for example, the X-direction) and protruding, as described above. For example, the substrate 101 may be a semiconductor substrate, such as a silicon substrate or a germanium substrate, or a silicon-on-insulator (SOI) substrate. Referring to FIGS. 3A and 3B, an isolation layer 110 may define the active pattern 105. The isolation layer 110 may be disposed on the substrate 101 to cover a side surface of the active pattern 105 of the substrate 101. The isolation layer 110 may be formed such that an upper region of the active pattern 105 is exposed. In some example embodiments, the isolation layer 110 may have a curved upper surface having a higher level as a distance from the active pattern 105 decreases. For example, the isolation layer 110 may include an oxide film, a nitride film, or a combination thereof.

In some example embodiments, the isolation layer 110 may be formed using a shallow trench isolation (STI) process. In some other example embodiments, the isolation layer 110 may further include a region more deeply extending below the upper surface of the substrate 101. The more deeply extending region may be also referred to as a deep trench isolation (DTI).

Referring to FIGS. 2 and 3B together with FIG. 1, an upper surface of the active pattern 105 may protrude from an upper surface of the isolation layer 110, as described above. A channel structure 130 according to some example embodiments includes four channel layers 131, 132, 133, and 134 disposed on the upper surface of the active pattern 105 to be spaced apart from each other in a direction (for example, the Z-direction), perpendicular to the upper surface of the substrate 101. However, the inventive concepts are not limited thereto, and the channel structure 130 may be implemented with a different number (for example, three) of channel layers.

As illustrated in FIG. 2, the gate structure 160 may include a gate electrode 165 extending in the second direction (for example, the Y-direction) and surrounding the plurality of channel layers 131, 132, 133, and 134, a gate insulating layer 162 disposed between the gate electrode 165 and the plurality of channel layers 131, 132, 133, and 134, spacers 164 disposed on side surfaces of the gate electrode 162, and a gate capping layer 166 disposed on the gate electrode 165.

As illustrated in FIG. 2, the gate insulating layer 162 may be disposed between the active pattern 105 and the gate electrode 165 and between the plurality of channel layers 131, 132, 133, and 134 and the gate electrode 165. The gate insulating layer 162 may be formed to surround the plurality of channel layers 131, 132, 133, and 134 in the second direction (for example, the Y-direction), and may extend from the upper surface of the active pattern 105 to the upper surface of the isolation layer 110 (see FIG. 3B). For example, the gate insulating layer 162 may include oxide, nitride, or a high-x material. The high-κ material may refer to a dielectric material having a dielectric constant higher than that of a silicon oxide film (SiO₂). The high-x material may include, for example, at least one of aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), and hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), and praseodymium oxide (Pr₂O₃).

The gate electrode 165 may be disposed on an upper portion of the active pattern 105 to fill a space between the plurality of channel layers 131, 132, 133, and 134 and extend to an upper portion of an uppermost fourth channel layer 134. The gate electrode 165 may be spaced apart from the plurality of channel layers 131, 132, 133, and 134 by the gate insulating layer 162. The gate electrode 165 may include a conductive material, for example, a metal nitride such as titanium nitride (TiN), tantalum nitride (TaN), or tungsten nitride (WN), and/or a metal material such as aluminum (Al), tungsten (W), or molybdenum (Mo) or a semiconductor material such as doped polysilicon. In some example embodiments, the gate electrode 165 may include two or more multiple layers.

Gate spacers 164 may be disposed on both side surfaces of the gate electrode 165. The gate spacers 164 may insulate source/drain regions 140A and gate electrodes 165 from each other. In some example embodiments, the gate spacers 164 may have a multilayer structure. For example, the gate spacers 164 may include oxide, nitride, and oxynitride, and may include, particularly, a low-x film.

Referring to FIGS. 1 and 2, the channel structure 130 and the active pattern 105, positioned on both sides of the gate structure 160, may be partially removed to form a recess for the first source/drain patterns 140. Side surfaces of the plurality of channel layers 131, 132, 133, and 134 may be exposed through the recess, and the first source/drain patterns 140 may be in contact with both side surfaces of each of the plurality of channel layers 131, 132, 133, and 134 in the first direction (the X-direction).

Referring to FIG. 2, a width of each of the first to fourth channel layers 131, 132, 133, and 134 in the first direction (for example, the X-direction) may be the same as or similar to (for example, slightly narrower than) a width of the active pattern 105. The width of each of the first to fourth channel layers 131, 132, 133, and 134 in the first direction (for example, the X-direction) may be the same as or similar to a width of the gate structure 160. In some example embodiments, the widths of the first to fourth channel layers 131, 132, 133, and 134 may be slightly different from each other.

The first to fourth channel layers 131, 132, 133, and 134 may include a semiconductor material capable of providing a channel region. For example, the first to fourth channel layers 131, 132, 133, and 134 may be a semiconductor pattern such as silicon (Si), silicon germanium (SiGe), or germanium (Ge). In some example embodiments, the first to fourth channel layers 131, 132, 133, and 134 may be formed of a material (for example, silicon) the same as that of the substrate 101. In some example embodiments, regions of the first to fourth channel layers 131, 132, 133, and 134, adjacent to the first source/drain pattern 140, may include an impurity region.

The first source/drain patterns 140 according to some example embodiments may be source/drain patterns for a P-type MOSFET.

Referring to FIGS. 2 and 3A, the first source/drain patterns 140 may be disposed in the recess, and may include a semiconductor liner layer 141 (also referred to as a "first semiconductor liner layer) connected to side surfaces of the first to fourth channel layers 131, 132, 133, and 134, and a semiconductor filling layer 145 disposed on the semiconductor liner layer 141.

The semiconductor liner layer 141 may be disposed on one region of the active pattern 105 along each of the side surfaces of the plurality of channel layers 131, 132, 133, and 134. The semiconductor liner layer 141 may be disposed in the recess in the first direction (for example, the X-direction), and may provide a trench extending in the second direction (for example, the Y-direction) therein. The trench may be a deep trench extending to a depth at which the trench at least partially overlaps a lowermost first channel layer 131.

The semiconductor filling layer 145 may be formed to cover the semiconductor liner layer 141 by filling the trench. The semiconductor filling layer 145 may at least partially overlap the lowermost first channel layer 131 in a direction, horizontal to the upper surface of the substrate 101. In some example embodiments, a bottom portion of the semiconductor filling layer 145 may be positioned on a level lower than that that of the lowermost first channel layer 131, the levels taken from an upper surface of the substrate 101 for example.

The semiconductor liner layer 141 and the semiconductor filling layer 145 may have different compositions. The semiconductor liner layer 141 may include silicon-germanium (SiGe) doped with a P-type (or first conductivity-type) impurity. For example, the P-type impurity may be at least one of boron (B), gallium (Ga), and indium (In). In some example embodiments, the semiconductor liner layer 141 may be SiGe doped with B. In some example embodiments, the semiconductor liner layer 141 may include a first epitaxial layer including germanium (Ge) having a first concentration, and a second epitaxial layer including germanium (Ge) having a second concentration higher than the first concentration. For example, the first concentration may be 5 at% to 20 at%, and the second concentration may be 20 at% to 60 at%.

The semiconductor filling layer 145 may include an epitaxial layer having a composition capable of applying compressive stress. For example, the epitaxial layer included in the semiconductor filling layer 145 may include a germanium (Ge) concentration higher than that of the semiconductor liner layer 141. For example, the Ge concentration of the semiconductor filling layer 145 may be 70 at% or more. In some example embodiments, the Ge concentration of the semiconductor filling layer 145 may be 80 at% or more. For example, the epitaxial layer included in the semiconductor filling layer 145 may be Ge, SiGe, or GeSn. Referring to FIG. 3A, the first source/drain patterns 140, particularly the semiconductor filling layer 145, may have a pentagonal cross-section.

The semiconductor filling layer 145 according to some example embodiments may be formed in a "deep trench," as described above, and thus compressive stress may be effectively applied to the first to fourth channel layers 131, 132, 133, and 134 in a horizontal direction. The semiconductor filling layer 145 may include an epitaxial layer including germanium (Ge) as a main component thereof, and thus gallium (Ga) may be used as a P-type impurity suitable therefor. Even when the semiconductor filling layer 145 has a significantly high germanium concentration (for example, 70 at% or more), sufficient conductivity may be secured through such impurity doping.

An interlayer insulating layer 115 may be disposed on the isolation layer 110 to cover the first source/drain patterns 140 and the gate structure 160 (see FIG. 3A). For example, the interlayer insulating layer 115 may include at least one of oxide, nitride, and oxynitride, and may include a low-x material.

Referring to FIGS. 2 and 3A, the semiconductor device 100A according to some example embodiments may further include a first contact structure 190A passing through the interlayer insulating layer 115, and a first metal-semiconductor compound layer 180A between the first source/drain patterns 140 and the first contact structure 190A. The first metal-semiconductor compound layer 180A may lower contact resistance between the first source/drain patterns 140 and the first contact structure 190A. In some example embodiments, the first metal-semiconductor compound layer 180A may be disposed to cover upper surfaces of the first source/drain patterns 140, that is, the semiconductor liner layer 141 and the semiconductor filling layer 145.

In some example embodiments, the first metal-semiconductor compound layer 180A may be mainly formed by silicidizing a portion of the semiconductor filling layer 145. For example, the first metal-semiconductor compound layer 180A may include TiGe:Ga, TiSiGe:Ga, or TiGeSn:Ga.

An electrical signal may be applied to the first source/drain patterns 140 through the first contact structure 190A. The first contact structure 190A may be disposed on the first source/drain patterns 140. In some example embodiments, the first contact structure 180A may have a lower portion having a width narrower than that of an upper portion thereof. For example, the first contact structure 190A or the first metal-semiconductor compound layer 180A may overlap at least a portion of an uppermost fourth channel layer 134 in the horizontal direction. For example, the first contact structure 190A may include a metal material such as aluminum (Al), tungsten (W), or molybdenum (Mo). The first contact structure 190A may further include a barrier material film surrounding the metal material, such as titanium nitride (TiN), tantalum nitride (TaN), or tungsten nitride (WN).

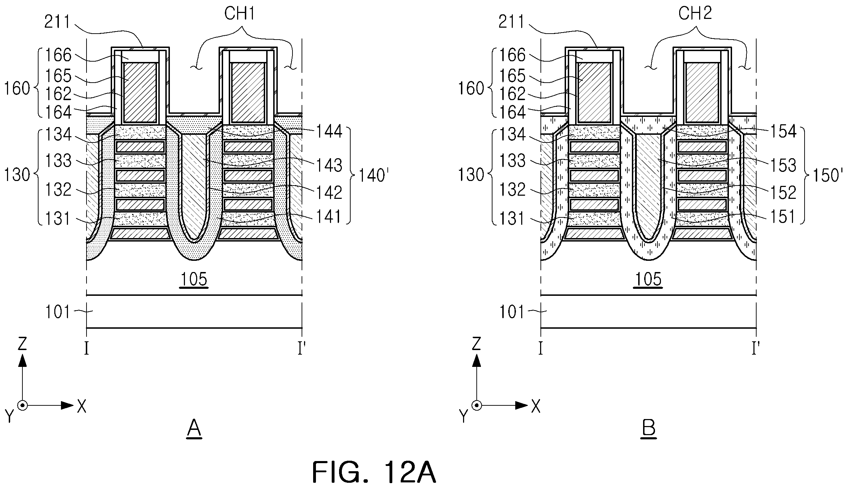

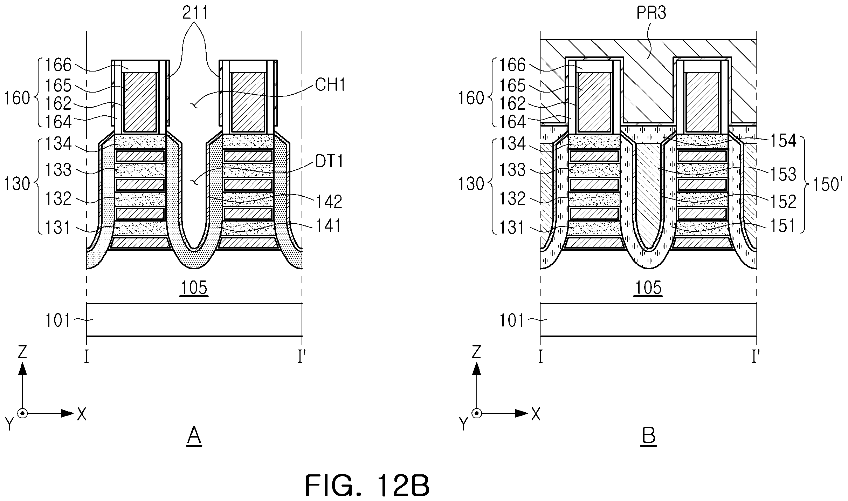

The first source/drain patterns 140 according to some example embodiments may provide a deep trench for forming the semiconductor filling layer 145. In some example embodiments, the deep trench may be defined by a first sacrificial filling layer 143 provided on the semiconductor liner layer 141, as described above. After the first sacrificial filling layer 143 (see FIGS. 12A and 12B) is removed, an ex-situ doping process may be performed. The doping process may be performed using plasma doping (PLAD) or ion implantation. A P-type impurity supplied in the doping process may have a unique concentration distribution in a boundary region between the semiconductor liner layer 141 and the semiconductor filling layer 145.

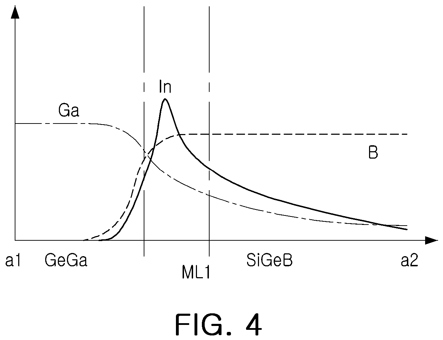

FIG. 4 is a graph illustrating a P-type impurity concentration distribution in the first source/drain pattern 140 of FIG. 2. The graph of FIG. 4 schematically illustrates a distribution of a P-type impurity concentration along a1-a2 in the first source/drain pattern 140 of FIG. 2.

Referring to FIG. 4, the semiconductor liner layer 141 may include silicon-germanium (SiGe:B) doped with boron (B), and the semiconductor filling layer 145 may include germanium (Ge:Ga) doped with gallium (Ga). As described above, an example is illustrated in which a surface of the semiconductor liner layer 141 is doped with indium (In), an additional P-type impurity, at a high concentration before the semiconductor filling layer 145 is formed. In a subsequent annealing process such as millisecond annealing (MSA) or nanosecond annealing (NSA), P-type impurities may diffuse into other adjacent layers 141 or 145. In particular, indium (In) doped at a high concentration may diffuse into the adjacent semiconductor liner layer 141 and semiconductor filling layer 145. However, a concentration of added indium (In) may have a concentration peak in a boundary region ML1 between the semiconductor liner layer 141 and the semiconductor filling layer 145.

Even when other P-type impurities (Ga and B) are injected into the semiconductor liner layer 141 before the semiconductor filling layer 145 is formed, the other P-type impurities (Ga and B) may have a concentration peak in the boundary region ML1 between the semiconductor liner layer 141 and the semiconductor filling layer 145.

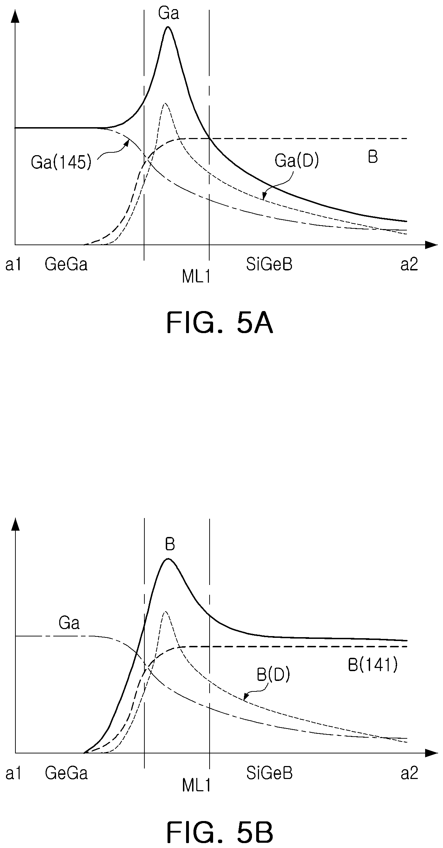

Referring to FIGS. 5A and 5B, in a similar manner as described above, the semiconductor liner layer 141 may include silicon-germanium (SiGe:B) doped with boron (B), and the semiconductor filling layer 145 may include germanium (Ge:Ga) doped with gallium (Ga).

The graph of FIG. 5A illustrates an example in which a surface of the semiconductor liner layer 141 is doped with gallium (Ga(D)), an additional P-type impurity, at a high concentration before the semiconductor filling layer 145 is formed. That is, the additional P-type impurity (Ga(D)) may be the same as a P-type impurity (Ga(145)) of the semiconductor filling layer 145. In impurity analysis of a final structure, a concentration distribution of gallium (Ga) (indicated by a solid line) may also have a concentration peak in the boundary region ML1 between the semiconductor liner layer 141 and the semiconductor filling layer 145.

The graph of FIG. 5B illustrates an example in which a surface of the semiconductor liner layer 141 is doped with gallium (B(D)), an additional P-type impurity, at a high concentration before the semiconductor filling layer 145 is formed. That is, the additional P-type impurity (B(D)) may be the same as a P-type impurity (B(141)) of the semiconductor liner layer 141. In impurity analysis of a final structure, a concentration distribution of boron (B) (indicated by a solid line) may also have a concentration peak in the boundary region ML1 between the semiconductor liner layer 141 and the semiconductor filling layer 145.

As such, in some example embodiments, a P-type impurity doping process may be performed on a surface for a deep trench from which the first sacrificial filling layer 143 (see FIGS. 12A and 12B) is removed, as an ex-situ doping process. A specific P-type impurity may have a unique concentration distribution in a boundary region between the semiconductor liner layer 141 and the semiconductor filling layer 145 by performing the doping processes.

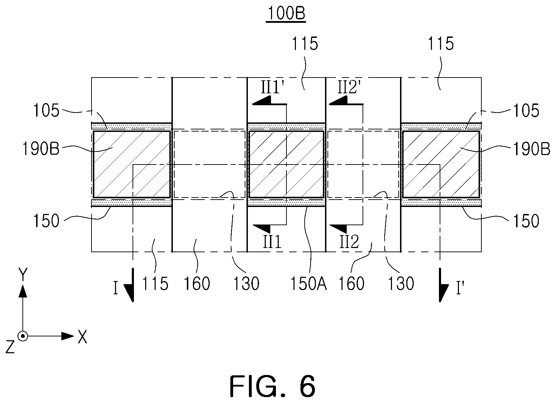

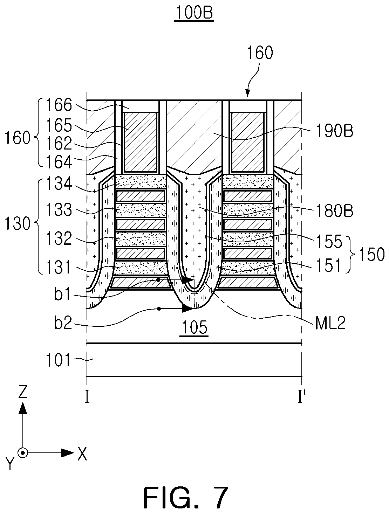

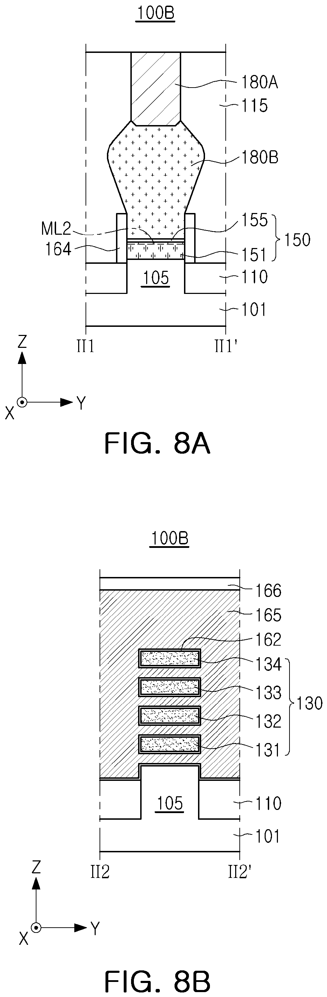

FIG. 6 is a plan view illustrating a semiconductor device according to some example embodiments of the inventive concepts. FIG. 7 is a cross-sectional view of the semiconductor device of FIG. 6 taken along line I-I'. FIGS. 8A and 8B are cross-sectional views of the semiconductor device of FIG. 6 taken along lines II1-II1' and II2-II2', respectively.

Referring to FIGS. 6, 7, 8A, and 8B, a semiconductor device 100B according to some example embodiments may be understood as being similar to the semiconductor device 100A illustrated in FIGS. 1 to 3B, except that a second source/drain pattern 150 (also referred to as "second active source/drain patterns") includes an N-type epitaxial layer, the semiconductor device 100B has a structure different from that of the first source/drain pattern 140 according to the above-described example embodiments, and a second metal-semiconductor compound layer is positioned in a deep trench. Unless otherwise stated, components according to example embodiments may be understood with reference to the description of the same or similar components of the semiconductor device 100A illustrated in FIGS. 1 to 3B. The semiconductor device 100A according to the above-described example embodiments may be implemented as a P-type MOSFET, whereas the semiconductor device 100B according to example embodiments hereinafter described with respect to FIGS. 6-9 may be understood as being implemented as an N-type MOSFET.

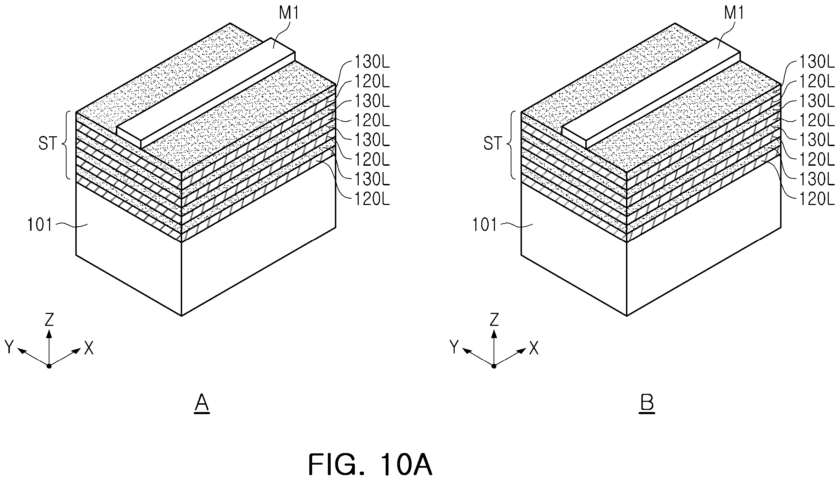

The semiconductor device 100B, an N-type MOSFET according to some example embodiments, may be formed in a different region of the same substrate, together with the semiconductor device 100A, a P-type MOSFET according to the above-described example embodiments. For example, two semiconductor devices 100A and 100B may be simultaneously formed on the same substrate 101 using the manufacturing process described with reference to FIGS. 10A to 10D, 11A to 11F, and 12A to 12F.

Referring to FIGS. 7 and 8A together with FIG. 6, the second source/drain patterns 150 according to some example embodiments may be source/drain patterns for an N-type MOSFET.

The second source/drain patterns 150 in source/drain regions 150A may include a semiconductor liner layer 151 (also referred to as a "second semiconductor liner layer") disposed in a recess and connected to side surfaces of first to fourth channel layers 131, 132, 133, and 134, and a semiconductor contact layer 155 disposed on the semiconductor liner layer 151.

The semiconductor liner layer 151 may be disposed on one region of an active pattern 105 along each of side surfaces of the plurality of channel layers 131, 132, 133, and 134. The semiconductor liner layer 151 may be disposed in the recess in a first direction (for example, an X-direction), and may provide a first trench extending in a second direction (for example, a Y-direction) therein. The semiconductor contact layer 155 may be conformally disposed on the semiconductor liner layer 151, and may provide a second trench extending in the second direction (for example, the Y-direction) therein, in a similar manner to the first trench. The second trench may be a deep trench extending to a depth at which the second trench at least partially overlaps a lowermost first channel layer 131. As such, the second source/drain patterns 150 may have a second trench space surrounded by the semiconductor contact layer 155.

The semiconductor liner layer 151 may include a first epitaxial layer doped with a second conductivity-type (N-type) first impurity. In some example embodiments, the semiconductor liner layer 151 may include a first silicon epitaxial layer intentionally undoped or doped with the first impurity at a first concentration, and a second silicon epitaxial layer doped with the first impurity at a second concentration higher than the first concentration. For example, the first silicon epitaxial layer may be Si, and the second silicon epitaxial layer may be silicon (Si:P) doped with phosphorus (P). The semiconductor contact layer 155 may include a second epitaxial layer doped with an N-type second impurity. In some example embodiments, the semiconductor contact layer 155 may be silicon doped with As and P (Si:As,P). For example, at least one of the N-type first and second impurities may include at least one of P, As, Sb, and Bi.

A second metal-semiconductor compound layer 180B according to some example embodiments may be formed to fill the deep second trench space in the semiconductor contact layer 155. Accordingly, the second metal-semiconductor compound layer 180B may overlap at least a portion of the lowermost first channel layer 131 among the plurality of channel layers 130 in a direction, horizontal to an upper surface of the substrate.

The second metal-semiconductor compound layer 180B may be mainly formed by silicidizing a portion of the semiconductor contact layer 155. The second metal-semiconductor compound layer 180B according to some example embodiments may include a material capable of applying tensile stress. For example, the second metal-semiconductor compound layer 180B may include TiSi:As,P. The second metal-semiconductor compound layer 180B according to some example embodiments may be formed in a "deep second trench," as described above, and thus tensile stress may be effectively applied to the first to fourth channel layers 131, 132, 133, and 134 in a horizontal direction. The second metal-semiconductor compound layer 180B may be formed in the "deep second trench," and thus may have a large contact area with the semiconductor contact layer 155 and may structurally greatly reduce contact resistance.

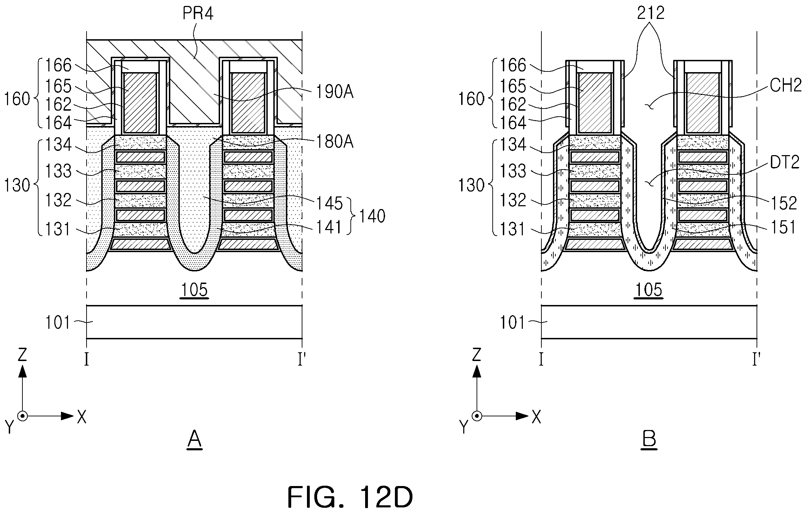

The second source/drain patterns 150 according to some example embodiments may provide a deep first trench for forming the semiconductor contact layer 155. In some example embodiments, the first trench may be defined by a second sacrificial filling layer 153 provided on the semiconductor liner layer 151, as described above. After removal of the second sacrificial filling layer 153 (see FIG. 12D), an ex-situ doping process may be performed. An N-type impurity supplied in the doping process may have a unique concentration distribution in a boundary region between the semiconductor liner layer 151 and the semiconductor contact layer 155.

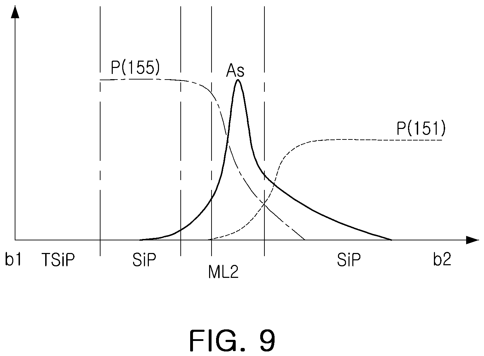

FIG. 9 is a graph illustrating an N-type impurity concentration distribution in the second source/drain pattern 150 of FIG. 7. The graph of FIG. 9 schematically illustrates an N-type impurity concentration distribution along b1-b2 in the second source/drain pattern 150 of FIG. 7.

Referring to FIG. 9, a semiconductor liner layer 151 may include silicon (SiP) doped with phosphorus (P), and a semiconductor contact layer 155 may include silicon (SiP) doped with phosphorus (P). As described above, an example is illustrated in which a surface of the semiconductor liner layer 151 is doped with arsenic (As), an additional N-type impurity, at a high concentration before the semiconductor contact layer 155 is formed. In a subsequent annealing process, N-type impurities may diffuse into other adjacent layers 151 or 155. In particular, arsenic (As) doped at a high concentration may diffuse into the adjacent semiconductor liner layer 151 and semiconductor contact layer 155. However, a concentration of added arsenic (As) may have a concentration peak in a boundary region ML2 between the semiconductor liner layer 151 and the semiconductor contact layer 155.

The semiconductor device 100A, a P-type MOSFET illustrated in FIGS. 1 and 2, and the semiconductor device 100B, an N-type MOSFET illustrated in FIGS. 6 and 7, may each be formed using a unique manufacturing process. Mainly, preliminary source/drain patterns including a sacrificial filling layer for a deep trench structure may be formed after a recess is formed, and a contact hole may be formed after an active gate structure 160 is formed. Subsequently, an epitaxial structure (for example, a P-type source/drain pattern 140) for compressive stress or a metal-semiconductor compound structure (for example, an N-type source/drain pattern 150) for tensile stress may be formed in each of deep trench spaces obtained by removing the sacrificial filling layer.

First and second source/drain patterns 140 and 150 according to some example embodiments may be formed in different regions of the same substrate. For example, two semiconductor devices 100A and 100B may be simultaneously formed on the same substrate 101 by the manufacturing process described in FIGS. 10A to 10D, 11A to 11F, and 12A to 12F.

FIGS. 10A to 10D are cross-sectional views illustrating a process of forming a fin structure and a dummy gate structure of a method of manufacturing a semiconductor device according to some example embodiments of the inventive concepts. A process of forming a fin structure FS and a dummy gate structure 170 may be performed in a first region A for a P-type MOSFET and a second region B for an N-type MOSFET of a substrate 101, in common.

First, referring to FIG. 10A, a semiconductor stack ST may be formed in which first semiconductor layers 120L and second semiconductor layers 130L are alternately stacked on the substrate 101. The semiconductor stack ST may be formed over the first region A and the second region B of the substrate 101.

The first semiconductor layers 120L may be removed in a subsequent process and used as a sacrificial layer, and the second semiconductor layers 130L may be used as a channel layer. The first semiconductor layers 120L and the second semiconductor layers 130L may include a semiconductor material such as silicon (Si) or silicon germanium (SiGe). In some example embodiments, the first semiconductor layers 120L and the second semiconductor layers 130L may include different semiconductor materials. The first semiconductor layers 120L may be formed of a material having a high etch selectivity with respect to the second semiconductor layers 130L. The second semiconductor layers 130L may include impurities, but the inventive concepts are not limited thereto.

In some example embodiments, the first semiconductor layers 120L may include silicon germanium (SiGe), and the second semiconductor layers 130L may include silicon (Si). The first semiconductor layers 120L and the second semiconductor layers 130L may be grown on the substrate 101 using an epitaxial growth process. Each of the first semiconductor layers 120L and the second semiconductor layers 130L may have a thickness ranging from about 1 nm to 100 nm.

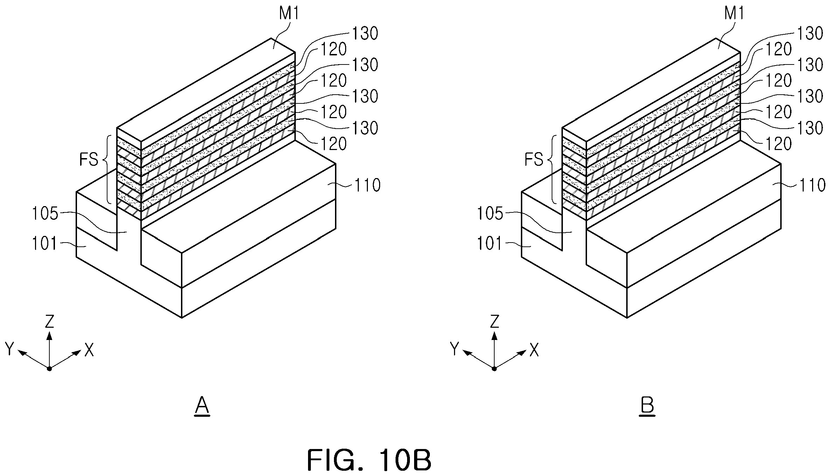

Referring to FIG. 10B, an active structure may be formed by removing a portion of the semiconductor stack ST and the substrate 101 using a first mask pattern M1 extending in a first direction (for example, an X-direction).

The active structure may include a portion of an active pattern 105 and the fin structure FS. The active pattern 105 may protrude from an upper surface of the substrate 101 by removing a portion of the substrate 101, and the fin structure FS may include first semiconductor patterns 120 and second semiconductor patterns 130 alternately stacked on the active pattern 105. The active pattern 105 and the fin structure FS may have a linear shape extending in a direction, for example, the first direction (for example, the X-direction). An isolation layer 110 may be formed in a region in which a portion of the substrate 101 is removed by filling an insulating material and then performing an etch-back process such that a portion of the active pattern 105 protrudes. That is, the etch-back process may be performed such that an upper surface of the isolation layer 110 is lower than an upper surface of the active pattern 105.

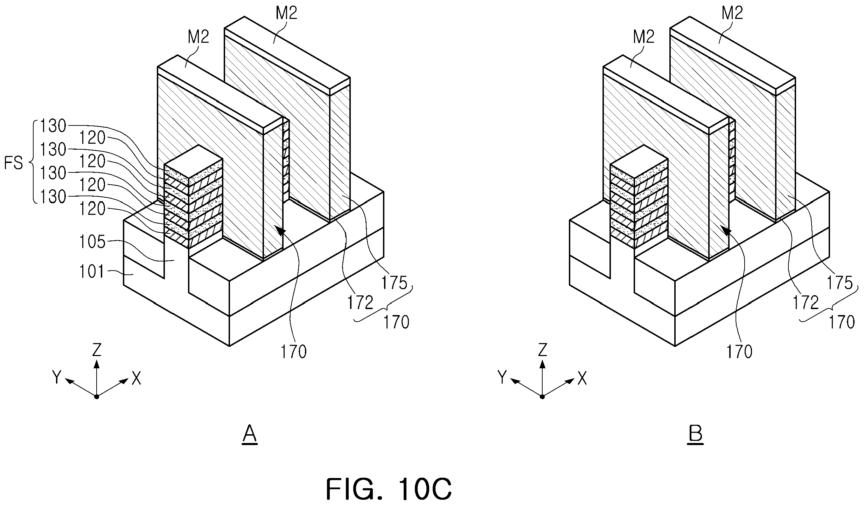

Referring to FIG. 10C, dummy gate structures 170, extending in a second direction (for example, a Y-direction), may be formed to intersect a portion of the active structure.

The dummy gate structures 170 may be sacrificial structures formed in regions of upper portions of the first to fourth channel layers 131, 132, 133, and 134 illustrated in FIG. 2 in which a gate insulating layer 162 and a gate electrode 165 are disposed, using a subsequent process. The dummy gate structures 170 may have a linear shape intersecting the active structures and extending in the second direction (for example, the Y-direction), and may be arranged to be spaced apart from each other in the first direction (for example, the X-direction). First and second sacrificial gate layers 172 and 175, sequentially stacked on the substrate 101 (in particular, the isolation layer 110) on which the active structure is formed, may be formed, and then a stack may be patterned using a second mask pattern M2, thereby forming the dummy gate structures 170 extending in the second direction (for example, the Y-direction). In some example embodiments, the first sacrificial gate layer 172 may include silicon oxide, and the second sacrificial gate layer 175 may include polysilicon. The second mask pattern M2 may include silicon oxide and/or silicon nitride.

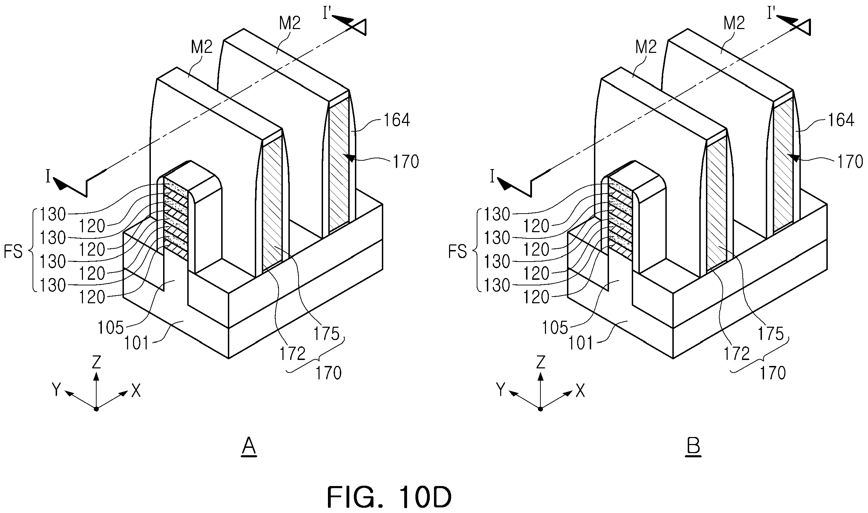

Referring to FIG. 10D, gate spacers 164 may be formed on both side surfaces of the dummy gate structures 170 and both side surfaces of the active structure, respectively.

A spacer material layer may be conformally formed on the dummy gate structure 170 and the active structure, and then anisotropic etching may be applied to form the gate spacers 164 on both side surfaces of the dummy gate structure 170. Portions of the gate spacers 164 may be provided on both side surfaces of the active structure, that is, on both side surfaces of the active pattern 105 and the fin structure FS. The both side surfaces on which the gate spacers 164 are formed may be side surfaces of the dummy gate structures 170, opposing each other in the first direction (for example, the X-direction). The gate spacers 164 may include, for example, at least one of SiO, SiN, SiCN, SiOC, SiON, and SiOCN.

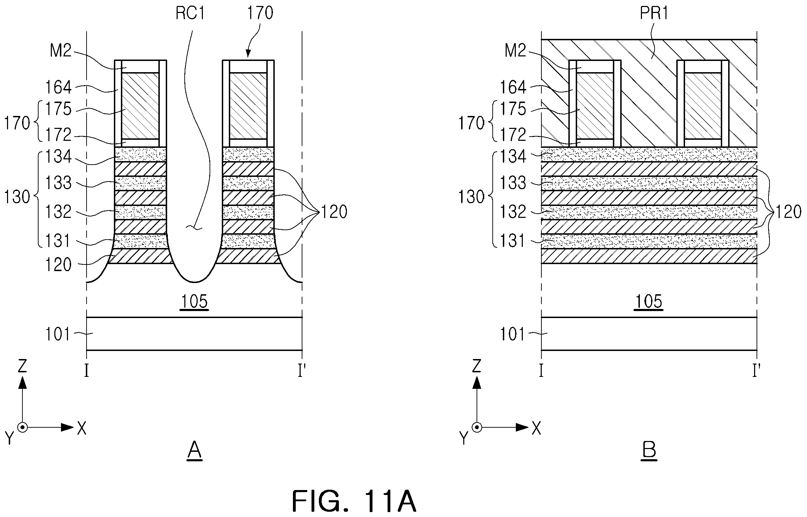

FIGS. 11A to 11F are cross-sectional views illustrating a process of forming a preliminary source/drain pattern of a method of manufacturing a semiconductor device according to some example embodiments of the inventive concepts. FIGS. 11A to 11F illustrate cross-sections of the semiconductor structure of FIG. 10D taken along line I-I'.

A subsequent process of forming first and second preliminary source/drain patterns 140' and 150' may be sequentially performed in a first region A for a P-type MOSFET and a second region B for an N-type MOSFET of a substrate 101.

Referring to FIG. 11A, a first photo mask PR1 may be formed in the second region B, and then portions of a fin structure FS, positioned on both sides of dummy gate structures 170, may be removed from the first region A to form a first recess RC1.

Here, sacrificial layers 120 may correspond to a first semiconductor pattern 120 illustrated in FIG. 11A, and channel layers 131, 132, 133, and 134 may correspond to a second semiconductor pattern 130 illustrated in FIG. 11A.

The exposed sacrificial layers 120 and channel layers 131, 132, 133, and 134 may be removed using a second mask pattern M2 and gate spacers 164 as a mask. Lengths of the channel layers 131, 132, 133, and 134 in a first direction (for example, an X-direction) may be determined using such a process. The sacrificial layers 120 and the channel layers 131, 132, 133, and 134 may be partially and additionally removed from side surfaces under the dummy gate structures 170, and each of the sacrificial layers 120 and the channel layers 131, 132, 133, and 134 has a width in the first direction (for example, the X-direction) smaller than a width of lower portions of a structure including the dummy gate structures 170 and the gate spacers 164.

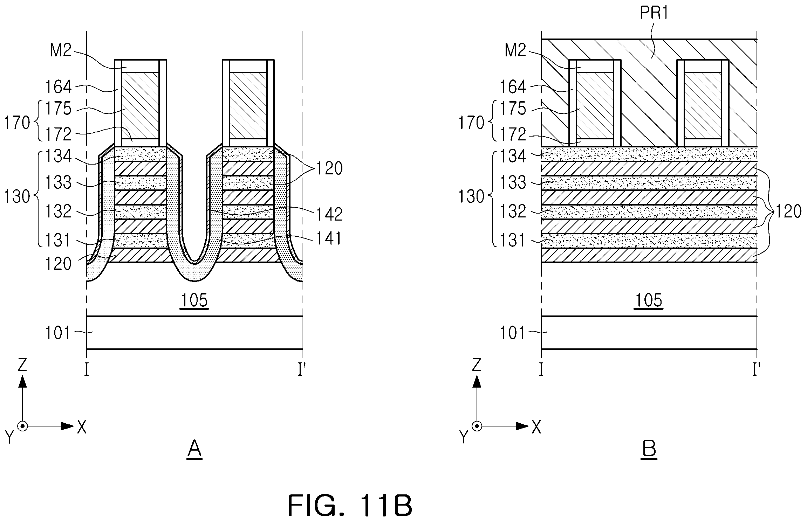

Referring to FIG. 11B, in the first region A, a first semiconductor liner layer 141 and a first blocking layer 142 may be sequentially formed in the first recess RC1 positioned on both sides of the dummy gate structures 170.

The first semiconductor liner layer 141 may be formed on a region of the active pattern 105 along each of side surfaces of the plurality of channel layers 131, 132, 133, and 134. In some example embodiments, the first semiconductor liner layer 141 may be SiGe doped with a P-type impurity (for example, B). In some example embodiments, the first semiconductor liner layer 141 may include a first epitaxial layer including germanium (Ge) having a first concentration, and a second epitaxial layer including germanium (Ge) having a second concentration, higher than the first concentration. For example, the first concentration may be 5 at% to 20 at%, and the second concentration may be 20 at% to 60 at%.

The first blocking layer 142 may be formed on the first semiconductor liner layer 141. The first blocking layer 142 may include a material having a selectivity with respect to a first sacrificial filling layer 143 to be formed in a subsequent process. For example, the first blocking layer 142 may include silicon.

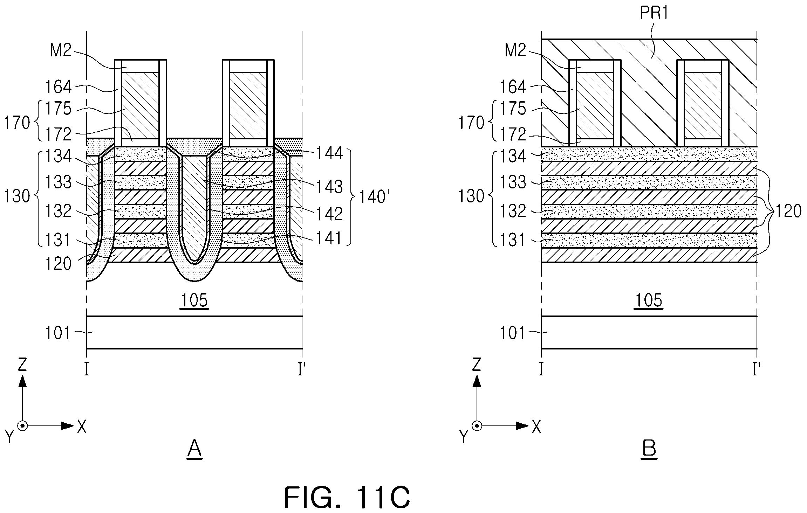

Referring to FIG. 11C, in the first region A, the first sacrificial filling layer 143 and a first semiconductor cap layer 144 may be formed on the first blocking layer 142 in the first recess RC1, thereby forming desired first preliminary source/drain patterns 140'.

The first sacrificial filling layer 143 may include silicon-germanium. For example, a germanium concentration of the first sacrificial filling layer 143 may be 5 to 70 at%. The first sacrificial filling layer 143 may define a deep trench space. Subsequently, a first semiconductor cap layer 144 may be formed to cover an upper surface of the first sacrificial filling layer 143. In some example embodiments, the first semiconductor cap layer 144 may include an epitaxial layer (for example, SiGe:B), the same as or similar to the first semiconductor liner layer 141. Accordingly, the first preliminary source/drain patterns 140' may be formed in the first recess RC1.

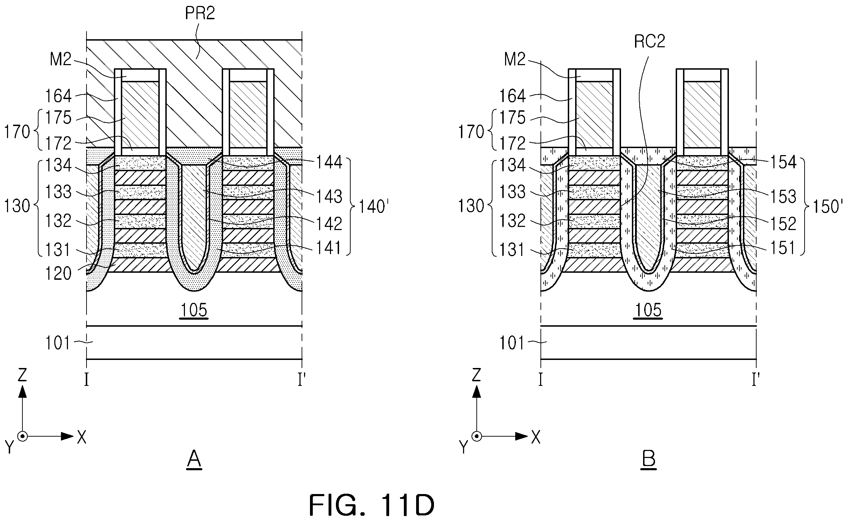

Referring to FIG. 11D, the first photo mask PR1 may be removed from the second region B of the substrate 101, and a second photo mask PR2, covering the first region A of the substrate 101, may be formed. Subsequently, a second recess RC2 may be formed in the second region B of the substrate 101, and then second preliminary source/drain patterns 150' may be formed.

In a similar manner to the processes illustrated in FIGS. 11A to 11C, the second preliminary source/drain patterns 150' may be provided by sequentially forming a second semiconductor liner layer 151, a second blocking layer 152, a second sacrificial filling layer 153, and a second semiconductor cap layer 154 in the second recess RC2. The second semiconductor liner layer 151 may include a first epitaxial layer doped with a second conductivity-type (N-type) first impurity. The second semiconductor liner layer 151 may be formed in the second recess RC2 in the first direction (for example, the X-direction). In particular, the second semiconductor liner layer 151 may be formed to have a first trench extending in a second direction (for example, a Y-direction) therein. In some example embodiments, the second semiconductor liner layer 151 may include a first silicon epitaxial layer intentionally undoped or doped with a first impurity at a first concentration, and a second silicon epitaxial layer doped with the first impurity at a second concentration, higher than the first concentration. For example, the first silicon epitaxial layer may be Si, and the second silicon epitaxial layer may be silicon (Si:P) doped with phosphorus (P).

Subsequently, the second blocking layer 152, the second sacrificial filling layer 153, and the second semiconductor cap layer 154 may be sequentially formed on the second semiconductor liner layer 151. The second blocking layer 152 may include a material having a selectivity with respect to the second sacrificial filling layer 153. For example, the second blocking layer 152 may include silicon, and the second sacrificial filling layer 153 may include silicon-germanium. For example, a germanium concentration of the second sacrificial filling layer 153 may be 5 to 70 at%, similar to that of the first sacrificial filling layer 143. The second semiconductor cap layer 154 may be formed to cover the second sacrificial filling layer 153. In some example embodiments, the second semiconductor cap layer 154 may include an epitaxial layer (for example, Si:P), the same as or similar to the second semiconductor liner layer 151.

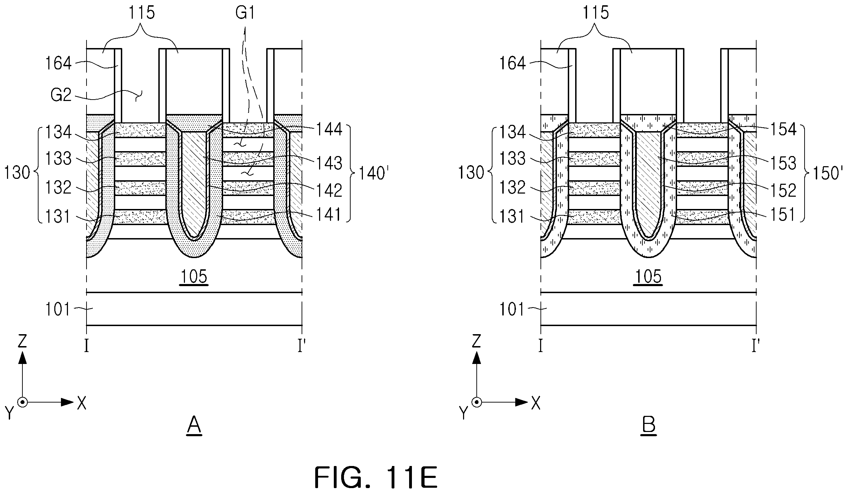

Referring to FIG. 11E, an interlayer insulating layer 115 may be formed, and the sacrificial layers 120 and the dummy gate structures 170 may be removed to form gap regions G1 and a gate space G2.

First, the interlayer insulating layer 115 may be formed by forming an insulating film, covering the dummy gate structures 170 and the first and second preliminary source/drain patterns 140' and 150', and performing a planarization process. The sacrificial layers 120 and the dummy gate structure 170 may be removed selectively with respect to the gate spacers 164, the interlayer insulating layer 115, and the channel layers 131, 132, 133, and 134. First, the gate space G2 may be formed by removing the dummy gate structures 170 together with the second mask pattern M2, and then the sacrificial layers 120 exposed through the gate space G2 may be removed to form gap regions G1. For example, when the sacrificial layers 120 include silicon germanium (SiGe) and the channel structure includes silicon (Si), the sacrificial layers 120 may be selectively removed by performing a wet etching process using peracetic acid as an etchant. During such a removal process, the first and second preliminary source/drain patterns 140' and 150' may be protected by the interlayer insulating layer 115.

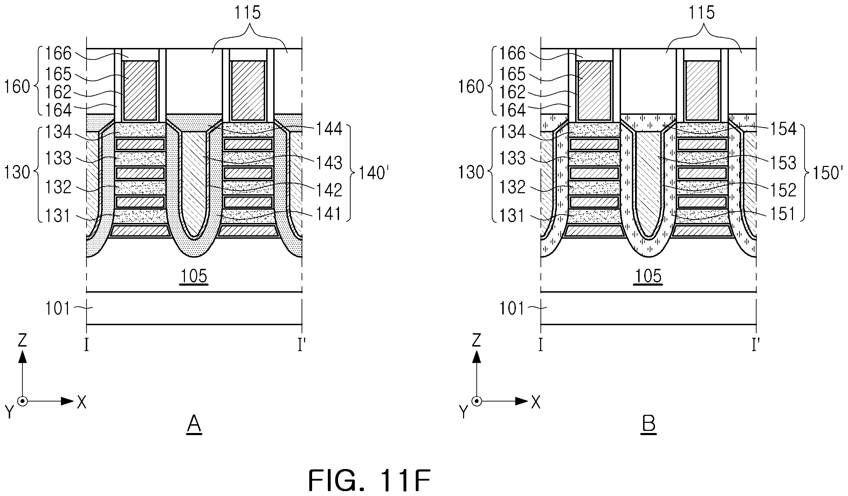

Referring to FIG. 11F, gate structures 160 may be formed in the gap regions G1 and the gate space G2.

A gate insulating layer 162 may be formed to conformally cover internal surfaces of the gap regions G1 and the gate space G2. The gate electrodes 165 may be formed to fill the gap regions G1 and the gate space G2 and then be removed from an upper portion of the gate space G2 to a desired (and/or alternatively predetermined) depth. A gate capping layer 166 may be formed in a region in which the gate electrodes 165 are removed from the gate space G2. Such processes may be used to form the gate structures 160 including the gate insulating layer 162, the gate electrode 165, the gate spacers 164, and the gate capping layer 166.

FIGS. 12A to 12F are cross-sectional views illustrating a process of forming first and second active source/drain patterns and first and second contact structures of a method of manufacturing a semiconductor device according to some example embodiments of the inventive concepts.

A subsequent process of forming first and second active source/drain patterns 140 and 150 may be sequentially performed in a first region A for a P-type MOSFET and a second region B for an N-type MOSFET of a substrate 101.

Referring to FIG. 12A, first and second contact holes CH1 and CH2, respectively connected to first and second preliminary source/drain patterns 140' and 150', may be formed to pass through an interlayer insulating layer 115 in the first and second regions, respectively, and a first insulating blocking layer 211 may be conformally formed to cover the first and second regions A and B. For example, the first insulating blocking layer 211 may include silicon nitride or aluminum nitride.

Referring to FIG. 12B, a third photo mask PR3 may be formed on the first insulating blocking layer 211 in the second region B, and the first preliminary source/drain pattern 140' may be selectively exposed in the first region A. Subsequently, a first semiconductor cap layer 144 and a first sacrificial filling layer 143 may be sequentially removed, forming a first trench DT1.

During a process of removing the first sacrificial filling layer 143, a first semiconductor liner layer 141 may be protected by a first blocking layer 142. The first blocking layer 142 may remain even after the process. An additional ex-situ doping process may be applied to the remaining first blocking layer 142. The doping process may be performed using plasma doping or ion implantation. An additional P-type impurity may be, for example, at least one of boron (B), gallium (Ga), and indium (In). In some example embodiments, no additional doping process may be applied. For example, when the remaining first blocking layer 142 has a significantly small thickness (for example, 1 nm or less), the P-type impurity may be diffused from the first semiconductor liner layer 141 or a semiconductor filling layer 145 in a subsequent process, such that no additional doping process may be required.

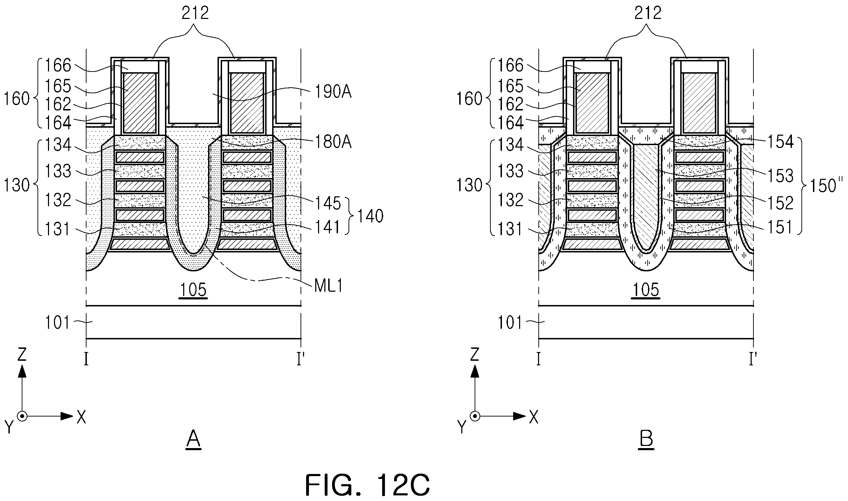

Referring to FIG. 12C, the first source/drain patterns 140 may be formed by forming the semiconductor filling layer 145 on the first semiconductor liner layer 141 in the first region A. Subsequently, after the third photo mask PR3 is removed from the second region B, a second insulating blocking layer 212 may be formed over the first and second regions A and B.

The semiconductor filling layer 145 may include an epitaxial layer having a composition capable of applying compressive stress. For example, the epitaxial layer included in the semiconductor filling layer 145 may have a germanium (Ge) concentration, higher than a germanium (Ge) concentration of the first semiconductor liner layer 141. For example, the Ge concentration of the semiconductor filling layer 145 may be 70 at% or more. For example, the epitaxial layer included in the semiconductor filling layer 145 may be Ge, SiGe, or GeSn. The semiconductor filling layer 145 may be formed in a "deep trench," as described above, and thus compressive stress may be effectively applied to a first to fourth channel layers 131, 132, 133, and 134 in a horizontal direction. In some example embodiments, the semiconductor filling layer 145 may be formed to cover an upper end of the first semiconductor liner layer 141 while filling a trench in the first semiconductor liner layer 141.

Before the second insulating blocking layer 212 is formed, the remaining first insulating blocking layer 211 may be removed. Before or after the third photo mask PR3 is removed, an additional annealing process may be applied to diffuse a P-type impurity doped into the remaining first blocking layer 142. The additionally diffused P-type impurity may have a unique concentration distribution in a boundary region ML1 between the first semiconductor liner layer 141 and the semiconductor filling layer 145 (see FIG. 4).

Referring to FIG. 12D, a fourth photo mask PR4 may be formed on the second insulating blocking layer 212 in the first region A, and the second preliminary source/drain pattern 150' may be selectively exposed in the second region B. Subsequently, a second semiconductor cap layer 154 and a second sacrificial filling layer 153 may be removed. Such a process may be performed in a similar manner to the process described with reference to FIG. 12B.

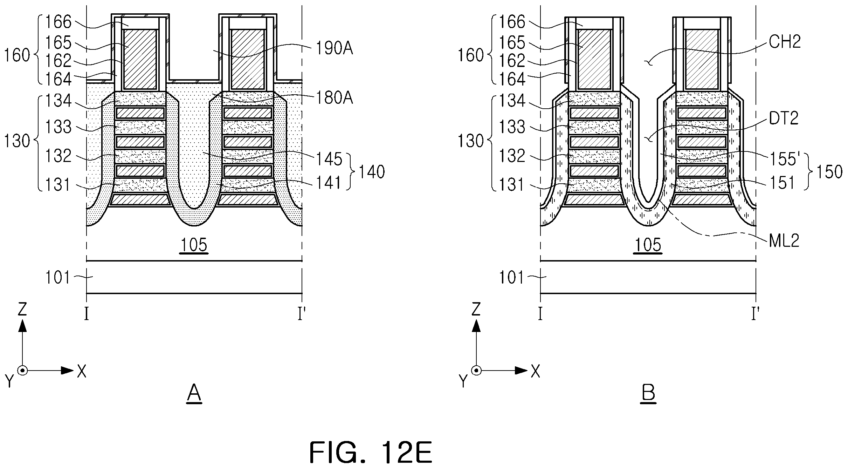

Referring to FIG. 12E, second source/drain patterns 150 may be formed by forming a semiconductor contact layer 155' on a second semiconductor liner layer 151 in the second region B. Subsequently, the fourth photo mask PR4 may be removed from the second region B.

The semiconductor contact layer 155' may be conformally disposed on the second semiconductor liner layer 151, and may be formed to have a second trench DT2 extending in a second direction (for example, a Y-direction), in a similar manner to a first trench, therein. For example, the second source/drain patterns 150 may include the semiconductor contact layer 155' covering the second semiconductor liner layer 151. The second source/drain patterns 150 may define the second trench. The semiconductor contact layer 155' may cover the second semiconductor liner layer 151 within the second trench. Before the semiconductor contact layer 155' is formed, a remaining second blocking layer may be doped with an N-type impurity. The N-type impurity may be diffused using an additional annealing process. For example, the N-type impurity may be at least one of P, As, Sb, and Bi. The additionally diffused N-type impurity may have a unique concentration distribution in a boundary region ML2 between the second semiconductor liner layer 151 and the semiconductor contact layer 155 (see FIG. 9).

In some example embodiments, no additional doping process may be applied. For example, when the remaining second blocking layer 152 has a significantly small thickness (for example, 1 nm or less), the N-type impurity may be diffused from the second semiconductor liner layer 151 or the semiconductor contact layer 155' in a subsequent process, such that no additional doping process may be required.

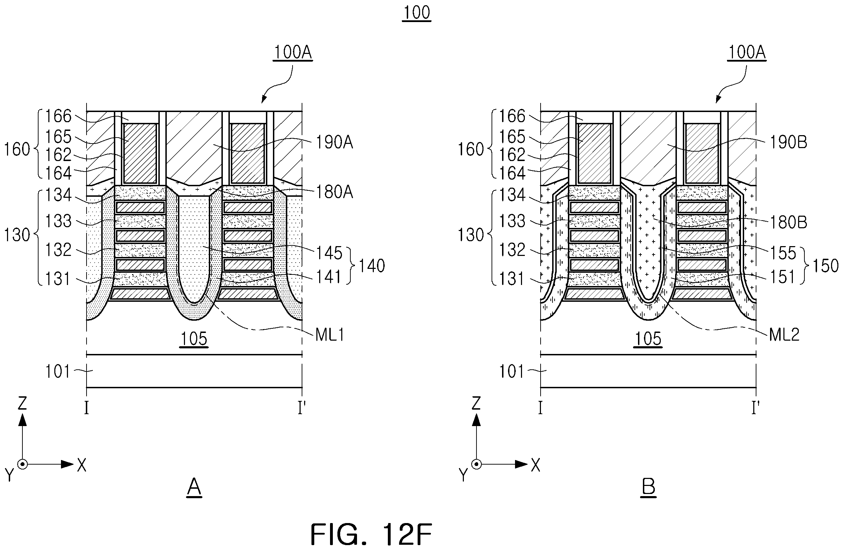

Referring to FIG. 12F, after the remaining second insulating blocking layer 152 is removed, upper regions of the semiconductor filling layer 145 and the semiconductor contact layer 155 may be silicidized to respectively form first and second metal-semiconductor compound layers 180A and 180B, and then to respectively form first and second contact structures 190A and 190B.

First, in the first region A, the upper region of the semiconductor filling layer 145 may be silicidized to form the first metal-semiconductor compound layer 180A. For example, the first metal-semiconductor compound layer 180A may include TiGe:Ga, TiSiGe:Ga, or TiGeSn:Ga. In the second region B, a portion of the semiconductor contact layer 155 may be silicidized to form the second metal-semiconductor compound layer 180B. The second metal-semiconductor compound layer 180B according to some example embodiments may include a material capable of applying tensile stress. For example, the second metal-semiconductor compound layer 180B may include TiSi:As,P. In particular, the second metal-semiconductor compound layer 180B may be formed in a "deep second trench", and thus tensile stress may be effectively applied to the first to fourth channel layers 131, 132, 133, and 134 in the horizontal direction in the second region B. The second metal-semiconductor compound layer 180B may be formed in the "deep second trench," and thus may have a large contact area with the semiconductor contact layer 155 and may greatly reduce contact resistance. Processes of forming the first and second metal-semiconductor compound layers 180A and 180B may be simultaneously performed. Subsequently, the first and second contact structures 190A and 190B, respectively connected to the first and second metal-semiconductor compound layers 180A and 180B, may be formed.

According to the above-described example embodiments, a first source/drain pattern (for example, a P-MOSFET) may have a deep trench doped with Ga, and may include a semiconductor filling layer containing Ge at a high concentration (for example, 70 at% or more). The semiconductor filling layer may effectively apply sufficient compressive stress to first channel layers. A second source/drain pattern (for example, an N-MOSFET) may include a metal-semiconductor compound layer (for example, TiSiAsP) providing tensile stress to the deep trench. The metal-semiconductor compound layer not only may reduce contact resistance through a sufficient contact area, but also may apply sufficient tensile stress to all second channel layers.

In some example embodiments, after a process of forming a deep trench (process of removing a SiGe layer), a process of additionally applying impurities to a remaining etching blocking layer (for example, Si) may be performed. Source/drain patterns may have an impurity concentration peak in a boundary region between a semiconductor liner layer and a semiconductor filling layer (semiconductor contact layer).

While example embodiments have been shown and described above, it will be apparent to those skilled in the art that modifications and variations could be made without departing from the scope of the inventive concepts as defined by the appended claims.

Embodiments are set out in the following numbered clauses:
1. A semiconductor device comprising:
   a substrate;
   an active pattern extending on the substrate in a first direction;
   a plurality of channel layers on the active pattern, the plurality of channel layers spaced apart from each other in a vertical direction perpendicular to an upper surface of the substrate;
   a gate structure crossing the active pattern, the gate structure surrounding the plurality of channel layers and extending in a second direction, the second direction being orthogonal to the first direction; and
   source/drain patterns on a region of the active pattern on both sides of the gate structure, the source/drain patterns having a semiconductor liner layer connected to each of side surfaces of the plurality of channel layers, and a semiconductor filling layer on the semiconductor liner layer,
   wherein the semiconductor liner layer includes silicon-germanium (SiGe) doped with a first conductivity-type impurity, and the semiconductor filling layer includes an epitaxial layer having a germanium (Ge) concentration greater than a Ge concentration of the semiconductor liner layer, and the epitaxial layer being doped with Ga.
2. The semiconductor device of clause 1, wherein the Ge concentration of the semiconductor filling layer is 70 at% or more.
3. The semiconductor device of clause 2, wherein the semiconductor filling layer includes Ge, SiGe or GeSn.
4. The semiconductor device of any preceding clause, wherein the semiconductor filling layer overlaps at least a portion of a lowermost channel layer from among the plurality of channel layers in a direction horizontal to the upper surface of the substrate.
5. The semiconductor device of any preceding clause, wherein the semiconductor liner layer includes a first epitaxial layer including germanium having a first concentration and a second epitaxial layer including germanium having a second concentration, the second concentration being greater than the first concentration.
6. The semiconductor device of clause 5, wherein
   the first concentration of the first epitaxial layer is 5 at% to 20 at%, and
   the second concentration of the second epitaxial layer is 20 at% to 60 at%.
7. The semiconductor device of any preceding clause, further comprising:
   a metal-semiconductor compound layer covering the semiconductor liner layer and the semiconductor filling layer; and
   a contact structure on the metal-semiconductor compound layer.
8. The semiconductor device of any preceding clause, wherein the first conductivity-type impurity includes at least one of B, Ga, and In.
9. The semiconductor device of clause 8, wherein a concentration distribution of the first conductivity-type impurity from the semiconductor liner layer to the semiconductor filling layer has a peak in a boundary region between the semiconductor liner layer and the semiconductor filling layer.
10. A semiconductor device comprising:
   a substrate;
   an active pattern extending on the substrate in a first direction;
   a plurality of channel layers on the active pattern, the plurality of channel layers spaced apart from each other in a vertical direction perpendicular to an upper surface of the substrate;
   a gate structure crossing the active pattern, the gate structure surrounding the plurality of channel layers and extending in a second direction, the second direction being orthogonal to the first direction;
   source/drain patterns on a region of the active pattern on both sides of the gate structure, the source/drain patterns having a semiconductor liner layer connected to each of side surfaces of the plurality of channel layers, and a semiconductor contact layer conformally on the semiconductor liner layer, wherein the source/drain patterns define trenches, and the semiconductor contact layer covers the semiconductor liner layer within the trenches; and
   a metal-semiconductor compound layer filling the trenches, the metal-semiconductor compound layer in contact with the semiconductor contact layer,
   wherein the semiconductor liner layer includes a first epitaxial layer doped with a second conductivity-type first impurity, and the semiconductor contact layer includes a second epitaxial layer doped with a second conductivity-type second impurity.
11. The semiconductor device of clause 10, wherein the metal-semiconductor compound layer overlaps at least a portion of a lowermost channel layer from among the plurality of channel layers in a direction horizontal to the upper surface of the substrate.
12. The semiconductor device of clause 10 or clause 11, wherein the semiconductor liner layer includes a first silicon epitaxial layer intentionally undoped or doped with the first impurity at a first concentration as the first epitaxial layer, and a second silicon epitaxial layer doped with the first impurity at a second concentration as the second epitaxial layer, and the second concentration being greater than the first concentration.
13. The semiconductor device of any of clauses 10 to 12, wherein at least one of the first and second impurities includes at least one of P, As, Sb, and Bi.
14. The semiconductor device of any of clauses 10 to 13, wherein
   the first impurity of the semiconductor liner layer includes P, and
   the second impurity of the semiconductor contact layer includes As and P.
15. The semiconductor device of any of clauses 10 to 14, wherein a concentration distribution of at least one of the first and second impurities from the semiconductor liner layer to the semiconductor contact layer has a peak in a boundary region between the semiconductor liner layer and the semiconductor contact layer.
16. A semiconductor device comprising:
   a substrate having a first region and a second region;
   a first active pattern and a second active pattern extending in a first direction respectively in the first region and the second region of the substrate;
   a plurality of first channel layers on the first active pattern, the plurality of first channel layers spaced apart from each other in a vertical direction perpendicular to an upper surface of the substrate;
   a plurality of second channel layers on the second active pattern, the plurality of second channel layers spaced apart from each other in the vertical direction;
   a first gate structure crossing the first active pattern, the first gate structure surrounding the plurality of first channel layers and extending in a second direction, the second direction being orthogonal to the first direction;
   a second gate structure crossing the second active pattern, the second gate structure surrounding the plurality of second channel layers and extending in the second direction;
   first source/drain patterns on a region of the first active pattern on both sides of the first gate structure, the first source/drain patterns having a first semiconductor liner layer connected to each of side surfaces of the plurality of first channel layers, and a semiconductor filling layer on the first semiconductor liner layer;
   second source/drain patterns on a region of the second active pattern on both sides of the second gate structure, the second source/drain patterns having a second semiconductor liner layer connected to each of side surfaces of the plurality of second channel layers, and a semiconductor contact layer conformally on the second semiconductor liner layer, wherein the second source/drain patterns define trenches, and the semiconductor contact layer covers the second semiconductor liner layer within the trenches;
   a first metal-semiconductor compound layer covering the first semiconductor liner layer and the semiconductor filling layer;
   a second metal-semiconductor compound layer filling the trenches, the second metal-semiconductor compound layer in contact with the semiconductor contact layer; and
   first and second contact structures disposed on the first and second metal-semiconductor compound layers, respectively,
   wherein the first semiconductor liner layer includes silicon-germanium (SiGe) doped with a first conductivity-type impurity, and the semiconductor filling layer includes an epitaxial layer having a germanium (Ge) concentration greater than a Ge concentration of the first semiconductor liner layer, and the epitaxial layer being doped with Ga, and
   the second semiconductor liner layer includes a first epitaxial layer doped with a second conductivity-type first impurity, and the semiconductor contact layer includes a second epitaxial layer doped with a second conductivity-type second impurity.
17. The semiconductor device of clause 16, wherein
   the semiconductor filling layer includes Ge, SiGe or GeSn, and
   the Ge concentration of the semiconductor filling layer is 70 at% or more.
18. The semiconductor device of clause 16 or clause 17, wherein
   the semiconductor filling layer overlaps at least a portion of a lowermost first channel layer from among the plurality of first channel layers in a direction horizontal to the upper surface of the substrate, and
   the second metal-semiconductor compound layer overlaps at least a portion of a lowermost second channel layer from among the plurality of second channel layers in the direction horizontal to the upper surface of the substrate.
19. The semiconductor device of any of clauses 16 to 18, wherein a concentration distribution of the first conductivity-type impurity from the first semiconductor liner layer to the semiconductor filling layer has a peak in a boundary region between the first semiconductor liner layer and the semiconductor filling layer.
20. The semiconductor device of any of clauses 16 to 19, wherein
   the first semiconductor liner layer includes a third epitaxial layer including germanium having a first concentration and a fourth epitaxial layer including germanium having a second concentration, the second concentration being greater than the first concentration,
   the first concentration of the third epitaxial layer is 5 at% to 20 at%, and
   the second concentration of the fourth epitaxial layer is 20 at% to 60 at%.
21. A method of manufacturing a semiconductor device, the method comprising:
   preparing, on a substrate, a fin-type structure including first semiconductor patterns and second semiconductor patterns that are formed of different materials and that are alternately stacked, and a dummy gate structure crossing the fin-type structure;
   forming first recesses for first source/drain patterns by removing portions of the fin-type structure on both sides of the dummy gate structure, wherein both side surfaces of the fin-type structure are exposed in the first recesses;
   forming gaps between the second semiconductor patterns by removing portions of the first semiconductor patterns below the dummy gate structure from the both side surfaces that are exposed;
   forming, in each of the first recesses, a first semiconductor liner layer from a bottom surface of the first recesses along side surfaces of the second semiconductor patterns, wherein the first semiconductor liner layer includes silicon-germanium (SiGe) doped with a first conductivity-type impurity;
   conformally forming a first blocking layer on the first semiconductor liner layer;
   forming a first sacrificial filling layer including SiGe on the first blocking layer, the first sacrificial filling layer filling the first recesses;
   forming a first semiconductor cap layer on the first sacrificial filling layer;
   forming an interlayer insulating layer on the substrate, the interlayer insulating layer covering the first semiconductor cap layer;
   removing the dummy gate structure and forming an active gate structure in a space from which the dummy gate structure is removed and in the gaps;
   forming a first contact hole in the interlayer insulating layer, the first contact hole extending to the first semiconductor cap layer;
   removing the first semiconductor cap layer and the first sacrificial filling layer from the first contact hole;
   providing a high concentration of first conductivity-type impurity to the first blocking layer;
   forming a semiconductor filling layer containing germanium, the semiconductor filling layer filling a space from which the first sacrificial filling layer is removed;
   forming a first metal-semiconductor compound layer by silicidizing an upper portion of the semiconductor filling layer; and
   forming a first contact structure connected to the first metal-semiconductor compound layer in the first contact hole.
22. A method of manufacturing a semiconductor device, the method comprising:
   preparing, on a substrate, a fin-type structure including first semiconductor patterns and second semiconductor patterns that are formed of different materials and that are alternately stacked, and a dummy gate structure crossing the fin-type structure;
   forming second recesses for second source/drain patterns by removing portions of the fin-type structure on both sides of the dummy gate structure, wherein both side surfaces of the fin-type structure are exposed in the second recesses;
   forming gaps between the second semiconductor patterns by removing portions of the first semiconductor patterns below the dummy gate structure from the both side surfaces that are exposed;
   forming, in each of the second recesses, a second semiconductor liner layer including silicon (Si) from a bottom surface of the second recesses along side surfaces of the second semiconductor patterns;
   conformally forming a second blocking layer on the second semiconductor liner layer;
   forming a second sacrificial filling layer including silicon germanium (SiGe) on the second blocking layer, the second sacrificial filling layer filling the second recesses;
   forming a second semiconductor cap layer on the second sacrificial filling layer;
   forming an interlayer insulating layer on the substrate, the interlayer insulating layer covering the second semiconductor cap layer;
   removing the dummy gate structure and forming an active gate structure in a space from which the dummy gate structure is removed and in the gaps;
   forming a second contact hole in the interlayer insulating layer, the second contact hole extending to the second semiconductor cap layer;
   removing the second semiconductor cap layer and the second sacrificial filling layer from the second contact hole;
   applying a second conductivity-type impurity to the second blocking layer;
   forming a semiconductor contact layer on the second blocking layer such that a trench from which the second sacrificial filling layer is removed remains;
   forming a second metal-semiconductor compound layer filling the trench by silicidizing a portion of the semiconductor contact layer; and
   forming a second contact structure connected to the second metal-semiconductor compound layer in the second contact hole.

## Claims

1. A semiconductor device comprising:
a substrate;
an active pattern extending on the substrate in a first direction;
a plurality of channel layers on the active pattern, the plurality of channel layers spaced apart from each other in a vertical direction perpendicular to an upper surface of the substrate;
a gate structure crossing the active pattern, the gate structure surrounding the plurality of channel layers and extending in a second direction, the second direction being orthogonal to the first direction; and
source/drain patterns on a region of the active pattern on both sides of the gate structure, the source/drain patterns having a semiconductor liner layer connected to each of side surfaces of the plurality of channel layers, and a semiconductor filling layer on the semiconductor liner layer,
wherein the semiconductor liner layer includes silicon-germanium (SiGe) doped with a first conductivity-type impurity, and the semiconductor filling layer includes an epitaxial layer having a germanium (Ge) concentration greater than a Ge concentration of the semiconductor liner layer, and the epitaxial layer being doped with Ga.

2. The semiconductor device of claim 1, wherein the Ge concentration of the semiconductor filling layer is 70 at% or more.

3. The semiconductor device of claim 2, wherein the semiconductor filling layer includes Ge, SiGe or GeSn.

4. The semiconductor device of any preceding claim, wherein the semiconductor filling layer overlaps at least a portion of a lowermost channel layer from among the plurality of channel layers in a direction horizontal to the upper surface of the substrate.

5. The semiconductor device of any preceding claim, wherein the semiconductor liner layer includes a first epitaxial layer including germanium having a first concentration and a second epitaxial layer including germanium having a second concentration, the second concentration being greater than the first concentration.

6. The semiconductor device of claim 5, wherein
the first concentration of the first epitaxial layer is 5 at% to 20 at%, and
the second concentration of the second epitaxial layer is 20 at% to 60 at%.

7. The semiconductor device of any preceding claim, further comprising:
a metal-semiconductor compound layer covering the semiconductor liner layer and the semiconductor filling layer; and
a contact structure on the metal-semiconductor compound layer.

8. The semiconductor device of any preceding claim, wherein the first conductivity-type impurity includes at least one of B, Ga, and In.

9. The semiconductor device of claim 8, wherein a concentration distribution of the first conductivity-type impurity from the semiconductor liner layer to the semiconductor filling layer has a peak in a boundary region between the semiconductor liner layer and the semiconductor filling layer.

10. The semiconductor device of any preceding claim, wherein
the semiconductor filling layer includes Ge, SiGe or GeSn, and
the Ge concentration of the semiconductor filling layer is 70 at% or more.

11. A method of manufacturing a semiconductor device, the method comprising:
preparing, on a substrate, a fin-type structure including first semiconductor patterns and second semiconductor patterns that are formed of different materials and that are alternately stacked, and a dummy gate structure crossing the fin-type structure;
forming first recesses for first source/drain patterns by removing portions of the fin-type structure on both sides of the dummy gate structure, wherein both side surfaces of the fin-type structure are exposed in the first recesses;
forming gaps between the second semiconductor patterns by removing portions of the first semiconductor patterns below the dummy gate structure from the both side surfaces that are exposed;
forming, in each of the first recesses, a first semiconductor liner layer from a bottom surface of the first recesses along side surfaces of the second semiconductor patterns, wherein the first semiconductor liner layer includes silicon-germanium (SiGe) doped with a first conductivity-type impurity;
conformally forming a first blocking layer on the first semiconductor liner layer;
forming a first sacrificial filling layer including SiGe on the first blocking layer, the first sacrificial filling layer filling the first recesses;
forming a first semiconductor cap layer on the first sacrificial filling layer;
forming an interlayer insulating layer on the substrate, the interlayer insulating layer covering the first semiconductor cap layer;
removing the dummy gate structure and forming an active gate structure in a space from which the dummy gate structure is removed and in the gaps;
forming a first contact hole in the interlayer insulating layer, the first contact hole extending to the first semiconductor cap layer;
removing the first semiconductor cap layer and the first sacrificial filling layer from the first contact hole;
providing a high concentration of first conductivity-type impurity to the first blocking layer;
forming a semiconductor filling layer containing germanium, the semiconductor filling layer filling a space from which the first sacrificial filling layer is removed;
forming a first metal-semiconductor compound layer by silicidizing an upper portion of the semiconductor filling layer; and
forming a first contact structure connected to the first metal-semiconductor compound layer in the first contact hole.
